(19) **Europäisches Patentamt**

**European Patent Office**

**Office européen des brevets**

(11) **EP 1 018 030 B1**

(12) **EUROPEAN PATENT SPECIFICATION**

(45) Date of publication and mention
of the grant of the patent:
**20.11.2002 Bulletin 2002/47**

(51) Int Cl.⁷: **G01R 31/28**, G01R 1/073

(21) Application number: **98942515.2**

(86) International application number:
**PCT/DK98/00392**

(22) Date of filing: **14.09.1998**

(87) International publication number:
**WO 99/014608 (25.03.1999 Gazette 1999/12)**

(54) **A METHOD OF CONTROLLING TEST PROBES IN A TESTING APPARATUS FOR ELECTRONIC PRINTED CIRCUIT BOARDS, AND AN APPARATUS FOR PERFORMING THE METHOD**

VERFAHREN ZUM REGELN VON TESTFÜHLERN IN EINEM TESTGERÄT FÜR ELEKTRONISCHE, GEDRUCKTE SCHALTUNGEN UND TESTGERÄT ZUR DURCHFÜHRUNG DES VERFAHRENS

PROCEDE DE CONTROLE DE SONDES D'ESSAI DANS UN APPAREIL D'ESSAI POUR CARTES ELECTRONIQUES DE CIRCUITS IMPRIMES ET APPAREIL PERMETTANT DE METTRE EN OEUVRE CE PROCEDE

(84) Designated Contracting States:
**DE DK FI FR GB IE IT**

(30) Priority: **15.09.1997 DK 105697**

(43) Date of publication of application:
**12.07.2000 Bulletin 2000/28**

(73) Proprietor: **TELLABS DENMARK A/S**
**2750 Ballerup (DK)**

(72) Inventor: **HAUSCHULTZ, Mikael**
**DK-2791 Dragor (DK)**

(74) Representative: **Wittrup, Flemming et al**
**Hofman-Bang Zacco A/S**
**Hans Bekkevolds Allé 7**
**2900 Hellerup (DK)**

(56) References cited:
EP-A2- 0 458 280        US-A- 4 427 250
US-A- 4 833 402        US-A- 5 390 283
US-A- 5 469 064

**Description**

The invention relates to a method of controlling test probes in a testing apparatus for electronic printed circuit boards.

In connection with the production of printed circuit boards the individual printed circuit board is tested, after the mounting of components, to verify that the printed circuit board or a selected part of it operates as desired. This type of test is frequently called in-circuit test. In case of mass production, this test is typically performed as an automatic test using a testing apparatus having a plurality of electrically conducting test probes. The testing apparatus is programmed to perform a sequence of test measurements, where the test probes are moved down on selected points on the printed circuit board to make electrical contact with these, following which the actual test measurement is performed between the probes. The points used in the individual test measurements are called test points below.

It is well-known, e.g. from EP A 0 458 280, to use a testing apparatus which has a plurality of inclined test probes, of which at least some have different access angles to the printed circuit board to be tested. The individual probe has a fixed angle relative to the printed circuit board to be tested, and the probe is moved in its longitudinal direction when accessing a test point on the printed circuit board. A testing apparatus of this type is used for testing to allow access to test points which are more closely spaced than is possible using parallel probes. The invention relates to such a testing apparatus in which the individual probe has a fixed access angle and thus has a fixed spatial direction of movement.

It is well-known to generate a test program for the testing apparatus using data on the actual printed circuit board from a print layout program, and, on the basis of an evaluation, to decide which points to measure, thereby preferably using points which are deemed to be most appropriate for this. This is done by mutually grading the test points using a priority system which allocate points to the individual test points on the basis of an evaluation of how accessible the individual test points are.

In the production of printed circuit boards operating at high frequencies, the components are placed closely spaced, and small soldering islands are used in the mounting of these. This is done inter alia to restrict the electromagnetic radiation. Use is moreover made of so-called SMD components which are surface-mounted so that the legs of the components are not passed through the printed circuit board to be soldered on the side opposite the component, but are soldered directly on the component side of the printed circuit board.

With this type of printed circuit board, which is called high frequency printed circuit board below, the prior art does not enable the above-mentioned testing apparatus to be used for testing. The reason is that the probes will frequently hit a component on the printed circuit board instead of the desired test point when accessing the test point in spite of the fact that the priority system ensures that the most suitable test points are used in the individual test measurement.

Accordingly, an object of the invention is to provide a method of testing printed circuit boards, including high frequency printed circuit boards.

This is achieved by performing the method as stated in the characterizing portion of claim 1.

The invention is based on the circumstance that it must be possible to perform the test of the printed circuit board with test probe access from the component side relative to a given test point. The control is optimized with respect to probe selection so that a probe having the most expedient spatial direction of movement with respect to a given test point is selected. This has the following advantages:

First, it is possible to test printed circuit boards where the components are more closely spaced, and where the test points are smaller than has been possible with the prior art. Thus, it is possible to test high frequency printed circuit boards among others.

Second, it is not necessary to have special measuring terminals on the printed circuit board, with the sole purpose of enabling test measurements, since the existing soldering islands and tracks may be used directly by the probes when performing a test measurement. This is an advantage for high frequency printed circuit boards, causing a reduction in the electromagnetic radiation.

Third, the test is reproducible, as the risk of measurement errors because of inexpedient test probe access to the printed circuit board is minimized. The reason is that less sensitivity to fault sources is achieved, such as e.g. that the printed circuit board is not quite plane or that the printed circuit board is not placed completely horizontally in the testing apparatus. The better reproducibility is of great importance for mass production where a large number of printed circuit boards are to be tested. A better reproducibility gives a time saving in a subsequent fault finding, since the number of boards to be examined in this fault finding because of test faults is minimized.

The evaluation of the expediency of a probe is made on an empirical basis, the expediency depending on a number of factors, as will appear from the following.

The optimization may advantageously be performed by using a point system, as stated in claim 2, thereby achieving a particularly simple embodiment.

The control may advantageously be optimized so that the selection of the most expedient direction of movement for a given probe is performed, as stated in claim 3, preferably by using test probes having a direction of movement which differs as little as possible from the perpendicular with respect to the printed circuit board. This provides the advantage that it ensures the best possible electrical contact between probe and test point.

It moreover provides the advantage that sliding of the probes on the test points is obviated. This problem might otherwise occur, when a probe having an inexpedient direction of movement with respect to an inclined surface of a test point is put down on the test point. Sliding of a probe on a test point might give rise to measurement errors.

When the control is optimized, as stated in claim 4, so as to allow for the position of the test point with respect to the component to which the test point is attached and the direction of movement of the test probes, it is ensured that probes having the most expedient directions of movement with respect to the given test points are mainly used.

As a result, the probes do not hit the components on the printed circuit board when accessing the printed circuit board, and the probes do not damage the components on the printed circuit board. A probe is otherwise likely to damage a component when attempting to make contact with a test point from an inexpedient side with its inclined direction of movement. The reason is that the component housing at the test point may "shade" the test point itself, so that the probe will hit the component housing when attempting to reach the test point. As the probe is pointed and made of a hard material, it is capable of damaging the component housing.

In addition to avoiding damage to the components on the printed circuit board, measurement errors caused by a probe hitting a component when accessing a test point is avoided.

As stated in claim 5, it is advantageous to consider the housing type of the component which is associated with the actual test point. This ensures that the height of the component may be allowed for, so that the probe selection may be made in dependence on this. This gives a greater flexibility, since it makes it possible to use a given probe on a test point at a relatively small component, even if this has a less expedient direction of movement with respect to the component, and to avoid using this probe in a similar situation where the component is relatively high and where the direction of movement is therefore more inexpedient.

When, as stated in claim 6, the control is optimized so as to allow for the direction of the track at the test point concerned so that the direction of movement of the probe corresponds with the direction of the track as best as possible, a greater tolerance is achieved to sliding of the test probe on the soldering island or the track when accessing a test point on the printed circuit board.

When the control is optimized so that the most expedient spatial direction of movement is selected in dependence on the distance between the test point and the adjacent component as well as the housing type of the adjacent component, as stated in claim 7, it is advantageously ensured that relatively low components positioned close to relatively high components may be accessed.

As stated in claim 8, it is expedient to find the optimum probe selection for a test step involving a plurality of test points by using arithmetic operations on the scores attached to these test points.

As stated in claim 9, it is expedient to use a system of points in the optimization so that a low score reflects a probe having an expedient direction, while a high score reflects a probe having an inexpedient direction. This gives rise to a particularly simple optimization, as the most expedient probe selection is the probe selection where the sum of the scores attached to the test points is lowest.

As stated in claim 10, the invention also relates to a testing apparatus for testing electronic printed circuit boards when performing optimization with respect to the probe selection, so that a probe having the most expedient spatial direction of movement with respect to a given test point is selected.

As stated in claim 11, the invention also relates to a readable computer medium, e.g. a diskette or a CD-ROM, whose contents may make a testing apparatus perform tests of printed circuit boards, as described above, thereby achieving a extension of the control of said testing apparatus with respect to the prior art.

As stated in claim 12, the invention moreover relates to a computer memory means containing a data structure which is used in connection with tests of printed circuit boards, as described above.

The invention will be described more fully below with reference to the drawing, in which

- fig. 1 shows an example of a typical probe position in tests with probes having access from the component side of a printed circuit board using the prior art,

- fig. 2 illustrates the access directions of the probes in a testing apparatus having four probes, as seen from the side, when the test probes are fed from the component side of the printed circuit board,

- fig. 3 illustrates the access directions of the probes in a testing apparatus, seen from above, when the test probes are fed from the component side of the printed circuit board,

- fig. 4 shows a flow chart of the allocation of points to a given probe configuration according to the invention,

- fig. 5 shows a flow chart of the overall function in connection with probe selection and probe position according to the invention, and

- fig. 6 shows an example of the probe position using a method according to the invention.

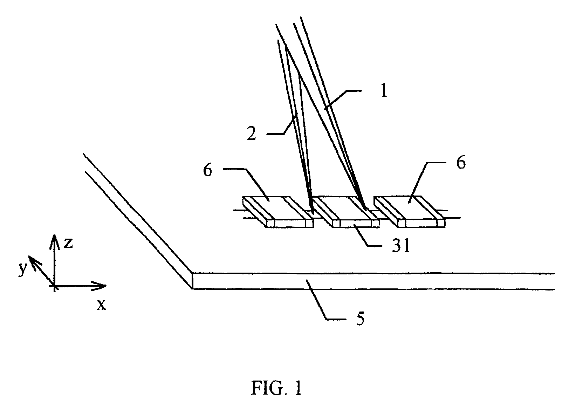

Fig. 1 shows an example of a typical probe position when a known testing apparatus having angled probes is used for testing a printed circuit board, with the probes fed from the component side. The figure shows part of a printed circuit board 5 on which a plurality of components 6, 31 are mounted. The shown components 6, 31 are so-called SMD components, which are mounted on the printed circuit board 5 by soldering on the component side of the printed circuit board.

It is contemplated that the printed circuit board is placed in an apparatus used for testing printed circuit boards so that the probes may attack test points from the component side of the printed circuit board. An apparatus for testing printed circuit boards has two or more test probes. Fig. 1 shows an example in which two of the test probes 1, 2 of the testing apparatus are used for performing a test measurement at the component 31.

When a test measurement is to be performed on the printed circuit board using the probes, the individual probe is first moved to a position above the test point concerned, and then the probe is moved down on the printed circuit board to make electrical contact with the test point.

The probes are angled with a fixed angle relative to the printed circuit board, so that the various probes have different directions of movement with respect to a test point. When the probe is moved down on the printed circuit board, it is moved in its longitudinal direction. The direction of movement of the individual probe to the printed circuit board will thus be equal to the direction of the probe.

The probe 2 is used for attacking a test point to the left of the component 31, while the probe 1 is used for attacking a test point to the right of the component 31. The shown probe selection is inexpedient, because the probe 1 hits the component 31 in its attempt at reaching the desired test point which is positioned immediately to the right of the component 31. Such situations occur frequently when probe selection and probe position are performed using a method according to the prior art.

The printed circuit board is positioned horizontally in the testing apparatus which is used by way of example. A system of right-angled (x,y,z) co-ordinates is inserted in fig. 1, so that the printed circuit board is positioned in the (x,y) plane.

Where according to the prior art a test point to be used by a given probe is selected, the following figures illustrate that it is more expedient to use the method of the invention which, when accessing a given test point, uses the probe which has the most expedient spatial direction of movement.

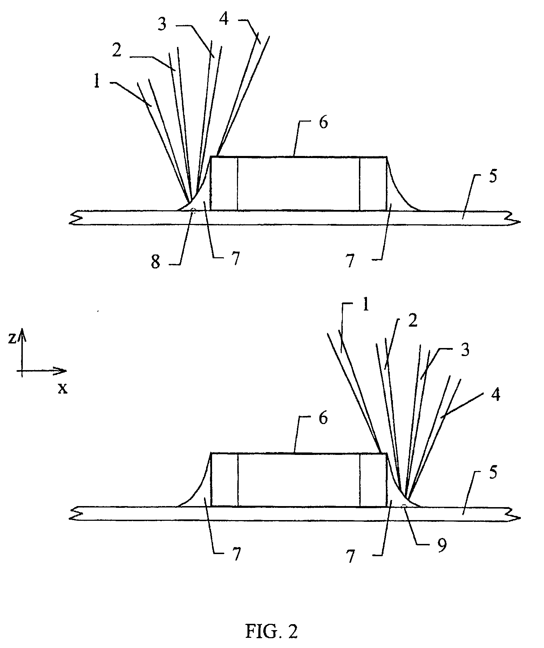

Fig. 2 corresponds to a section in parallel with the (x,z) plane in the inserted system of (x,y,z) co-ordinates, and shows part of a printed circuit board 5 on which an electronic component 6 is mounted. The component 6 is soldered to the printed circuit board at a plurality of soldering points 7. The so-called test points 8 and 9, which are used in the test of the printed circuit board, are positioned in connection with the soldering points 7, so that the probes are caused to contact the soldering point 7 in order to be connected with the test point. The figure shows an example where the testing apparatus has four test probes 1, 2, 3 and 4. This testing apparatus is used in the following figures.

The access directions of the four probes 1, 2, 3 and 4 are illustrated in the figure. In the (x,z) plane, the probes 2 and 3 both have a more acute angle with respect to the normal plane of the printed circuit board 5 than the probes 1 and 4. The probes are angled correspondingly in the (y,z) plane, and the probes 2 and 3 thus both have a direction of movement which differs less from the vertical than is the case with the probes 1 and 4. This means that the probes 2 and 3 have an access angle which differs less from the perpendicular with respect to the printed circuit board than the probes 1 and 4.

The upper part of fig. 2 illustrates the directions in which the individual probes 1, 2, 3 and 4 will attack the printed circuit board in an attempt at accessing the test point 8, when the test point is positioned to the left in the figure. In the performance of a test measurement, the probes will not attack the same test point of course, but fig. 2 nevertheless shows this situation, as it illustrates the various directions of movements of the probes. When attempting to reach the test point 8, the probe 4 will hit the component housing, and it is therefore not expedient to use this probe in this situation. The probes 1, 2 and 3, on the other hand, may be used, since these hit the soldering point 7 at the test point 8.

The figure, at the bottom, correspondingly shows the directions in which the various probes 1, 2, 3 and 4 will attack the printed circuit board in an attempt at accessing the test point 9, which is positioned to the right in the figure. In this situation, the probe 1 will hit the component housing and will therefore not be expedient to use. The probes 2, 3 and 4, on the other hand, may be used.

The two parts of the figure thus illustrate that the various probes are more or less suitable for a given test point, and that the suitability of the probes depends on the direction of movement to a given test point.

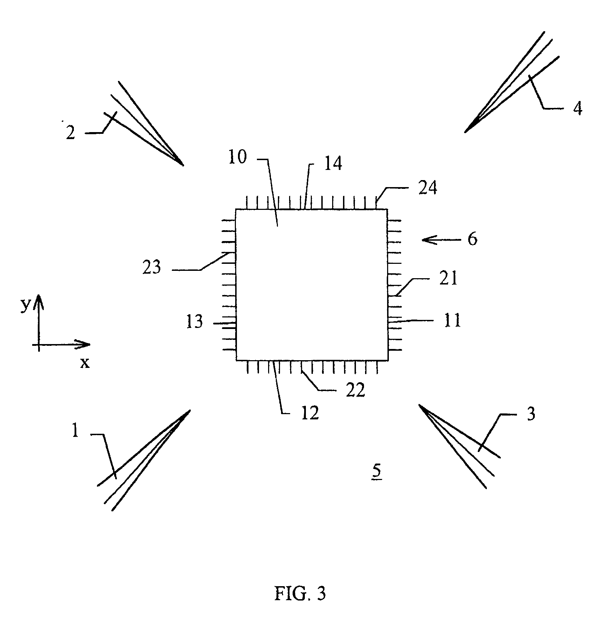

Fig. 3, like fig. 2, illustrates the access directions of the probes in a testing apparatus, but shows the situation from another angle. The figure shows an electronic component 6 which is mounted on a printed circuit board 5 present in the (x,y) plane. The component 6 comprises a component housing 10 and a plurality of component legs 21, 22, 23 and 24. The figure also shows four test probes 1, 2, 3 and 4 which have different access directions to the printed circuit board 5.

As described in connection with fig. 2, the individual probe will be better suited for tests at some points than others. This also appears from fig. 3 in which the test probe 1 attacks in an inclined direction from below and from the left in the figure. Correspondingly, the test probe 2 attacks in an inclined direction from the left and from above, the probe 3 in an inclined direction from the right and from below, and the probe 4 in an inclined direction from above and from the right in the figure.

When the probes are angled, as illustrated in fig. 3, the probes 1 and 2 will be the probes which are best suitable for a measurement on a test point which is positioned at a component leg 23 on the component side 13. Correspondingly, the probes 2 and 4 will be the most suitable ones when accessing a test point at a component leg 24 which is positioned at the component side 14. The probes 3 and 4 will be the most suitable ones when accessing test points at a component leg 21 at the component side 11, while the probes 1 and 3 will be the most suitable ones when accessing test points at a component leg 22 at the component side 12.

It is noted that the probes 2 and 3 may also be used on other sides with respect to the component because of their relatively small deviation from the vertical direction of movement. For example, it is thus possible to use all the probes 1, 2 and 3 when accessing a test point at a component leg 23, and to use all the probes 2, 3 and 4 when accessing a test point at a component leg 21, which corresponds to the situations shown in fig. 2.

A testing apparatus programmed to perform a desired sequence of test measurements is used in an automatic test of printed circuit boards. The test program consists of a plurality of steps in which the individual step indicates one or more test measurements which are to be performed. The individual step, called a test step below, indicates which point the individual test probe is to attack, and which test measurement is to be performed between the individual probes.

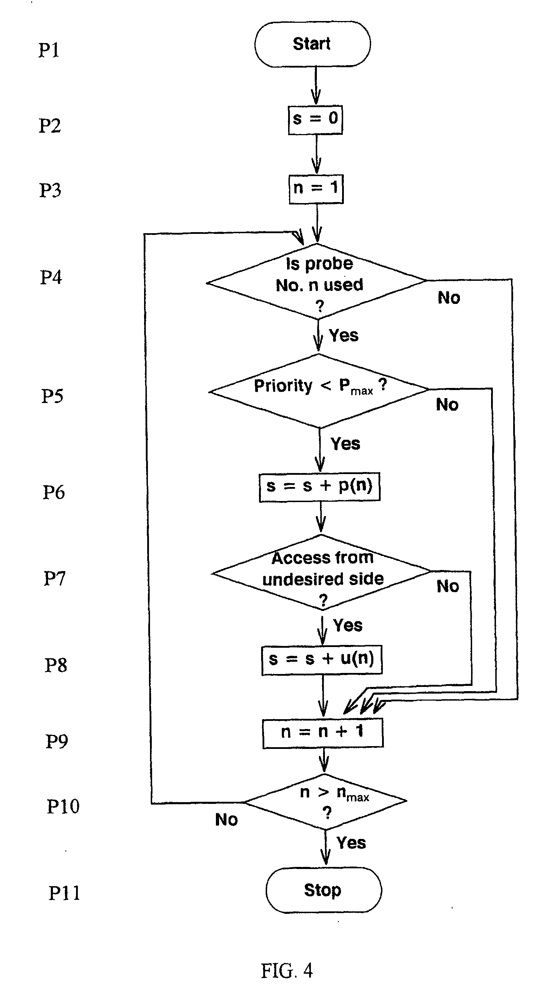

The test program is optimized so that the most expedient probes are used in the individual test step to achieve the advantages mentioned in the preamble. The optimization is performed using a system of points which reflects the optimization rules used. In the use of this system of points, a score is allocated to the individual test steps. The score reflects how suitable the probe configuration is for use in the test measurement concerned, so that a low score is allocated to a suitable probe configuration, while a high score is allocated to an unsuitable probe configuration. The allocation of points forms the basis for the optimization of the test program and is illustrated in fig. 4.

Fig. 4 shows a flow chart of an allocation of points according to the invention, a score being calculated for the individual test step on the basis of knowledge of the spatial direction of movement of the probes, the positions of the test points with respect to the associated component, and the directions of movement of the probes.

The method starts from step P1 and continues from there to steps P2 and P3, in which the score s and the probe number n concerned are initialized to 0 and 1, respectively. The method continues from step P3 in step P4, in which it is checked whether the probe n is used in the test step concerned. If this is not the case, the method jumps to step P9, in which the probe number n is counted 1 up, and continues from step P9 to step P10, in which it is checked whether points have been allocated to all the probes of the testing apparatus. If this is not the case, the method jumps to step 4, otherwise the allocation of points is terminated by continuing to step P11.

If it is determined in step P4 that the probe n is used, the method proceeds to step P5. The so-called priority is used in step P5. The priority is a number which is attached to the individual test points, and it indicates how suitable a point is as a test point. The priority may be attached on the basis of an evaluation of the accessibility of the test point, and may thus provide the basis for primarily using the best accessible test points. For example, a high priority number is attached to a test point when the probes are evaluated to have good access to this test point, while a low score is attached to a test point when the probes are evaluated to have poor access to the point. It is checked in step P5 whether the priority is greater than a given value $P_{max}$, e.g. greater than or equal to 105. If this is the case, the probe access is considered to be so good in this situation that any of the probes may be used. In this situation, there is no need for allocation of points, and the method therefore jumps to step P9, from which it proceeds as described above. If, on the other hand, the priority is less than the given limit value, the method continues in step P6.

In step P6, points are allocated to the probe concerned on the basis of its direction of movement to a printed circuit board in the apparatus. This allocation of points is carried out as a look-up in a table which contains values reflecting an evaluation of the probes of the apparatus. This will be described more fully below.

The probes 1 and 4 are evaluated to be equally useful in the testing apparatus which is illustrated in the figures. This evaluation is made on the basis of the direction of movement of the probes to the printed circuit board to be tested. Correspondingly, the probes 2 and 3 are evaluated to be equally useful. Since the probes 2 and 3 have a direction of movement which differs less from the vertical than is the case with the probes 1 and 4, these are generally more expedient to use since they will give the greatest accuracy. The reason is that the risk of a probe hitting a component or sliding on a soldering island is smaller when the probe used has a direction of movement which differs relatively little from the vertical. Probes having a direction of movement which does not differ considerably from the vertical have the additional advantage that they are known to prove a better electrical contact with the soldering island. These considerations are reflected by the allocation of points in the following table. In the allocation of points, a low score illustrates that a probe is good, while a high score illustrates that a probe is poor for use at the given test point.

| n | 1 | 2 | 3 | 4 |
|---|---|---|---|---|
| p(n) | 30 | 0 | 0 | 30 |

The table shows that the use of the probe 1 causes addition of 30 points to the score of this probe, while 0 point is added to the score of the probe 2 when this probe is used. Correspondingly, 0 and 30 points, respectively, are added to the scores of the probes 3 and 4, if these are used.

The method proceeds from step P6 to step P7, in which it is evaluated whether the probe concerned attacks from an unfortunate side with respect to the test point and the component at the test point. It is evaluated how easy the probe can get down to the test point. This evaluation is made by first determining where the test point is positioned with respect to the component to which it is attached.

The determination of the position of a test point with respect to the attached component may be made in several ways. A relatively simple manner is used in this connection which is advantageous in that it does require much computation. The stated method works for components which are positioned axis-parallel, or at least approximately axis-parallel, with respect to the system of co-ordinates of the testing apparatus.

First the following quantities, which correspond to axis-parallel lines in the system of co-ordinates of the testing apparatus, are calculated:

$$x_{min} = \min(x_1, x_2, \cdots, x_n)$$

$$x_{max} = \max(x_1, x_2, \cdots, x_n)$$

$$y_{min} = \min(y_1, y_2, \cdots, y_n)$$

$$y_{max} = \max(y_1, y_2, \cdots y_n)$$

wherein $(x_1, y_1), (x_2, y_2), \cdots, (x_n, y_n)$ are the sets of co-ordinates of the individual test points which are attached to the component concerned. Then, the following distances are determined, the test point concerned having the set of co-ordinates $(x, y)$ :

$$E = |x - x_{max}|$$

$$W = |x - x_{min}|$$

$$N = |y - y_{max}|$$

$$S = |y - y_{min}|$$

The smallest one of the distances above indicates the position of the test point with respect to the component housing. The case $E = \min(E, W, N, S)$ indicates that the test point concerned is located to the right of the component. Correspondingly, the three cases $W = \min(E, W, N, S)$, $N = \min(E, W, N, S)$ and $S = \min(E, W, N, S)$ will correspond to a position of the test point concerned to the left of, above and below the component, respectively.

In view of the determination of the position of a test point with respect to the component to which it is attached, the possibility of the probe reaching the test point is evaluated. For example, it appears from fig. 3 that the probe 1 may be used for attacking a test point at the sides 12 and 13, but not readily for attacking a test point at the sides 11 and 14. If it is evaluated in step P7 that the probe attacks from an unfortunate side, points are allocated by a table look-up in step P8. If, on the other hand, it is determined that the probe does not attack from an unfortunate side, no points are allocated, and the method jumps to step P9.

It will be described below how it is evaluated whether the probe concerned, when attacking the test point, causes access from an unfortunate side with respect to the component at the test point.

If the probe used attacks the test point from an undesired side, points are allocated, as appears from the following table which is listed for the testing apparatus used.

| n | 1 | 2 | 3 | 4 |
|------|-----|----|----|-----|
| u(n) | 200 | 90 | 90 | 200 |

The table illustrates that it is more inexpedient to use the probe 1 or the probe 4 from an undesired side than to use the probe 2 or the probe 3 from an undesired side. The reason is that the probes 1 and 4 have a more horizontal access to the printed circuit board and will therefore tend to cause more problems when accessing a test point.

The number of the probe concerned is counted 1 up in step P9, and then the method continues in step P10. If there are no more probes in the testing apparatus, the method proceeds to step P11 to terminate the allocation of points, otherwise it jumps to step P4, and points are allocated to the newly selected probe.

The purpose of the allocation of points described above is to form the basis for an optimization which increases the accuracy of the probes when accessing the test probes. The test program is optimized by using probes having an access angle which differs least from the vertical, and by making probe selections so as to use probes which attack a given test point from the most expedient side with respect to the attached component. However, it should be mentioned that the allocation of points may of course be made in a corresponding manner for other conditions that might be deemed to influence the accuracy. Some examples of which other conditions may also be considered in the allocation of points will be given below.

The score allocated to a probe when attacking a test point from an undesired side may e.g. depend on the type of the component to which the point is attached. This permits e.g. the allocation of more points when an undesired probe access occurs at a relatively high component than at a relatively low component, as the risk of the probes hitting the component is greater in this situation.

Allowance may be made for adjacent components in the allocation of points, so that an adjacent component positioned within a given distance from the test point concerned gives rise to an allocation of points which reflect the possibility of probe access to the test point. The distance from the test point to the adjacent component may be calculated on the basis of data from the print layout. This allocation of points may e.g. depend on the type of the adjacent component so that the height of the component is allowed for.

Allowance may be made for the direction of the track at the test point concerned, so as to ensure that the access direction of the probe corresponds with the direction of the track as best as possible.

The above-mentioned optimization rules may be implemented in a corresponding manner as shown in fig. 4, where the allocation of points merely reflects these rules.

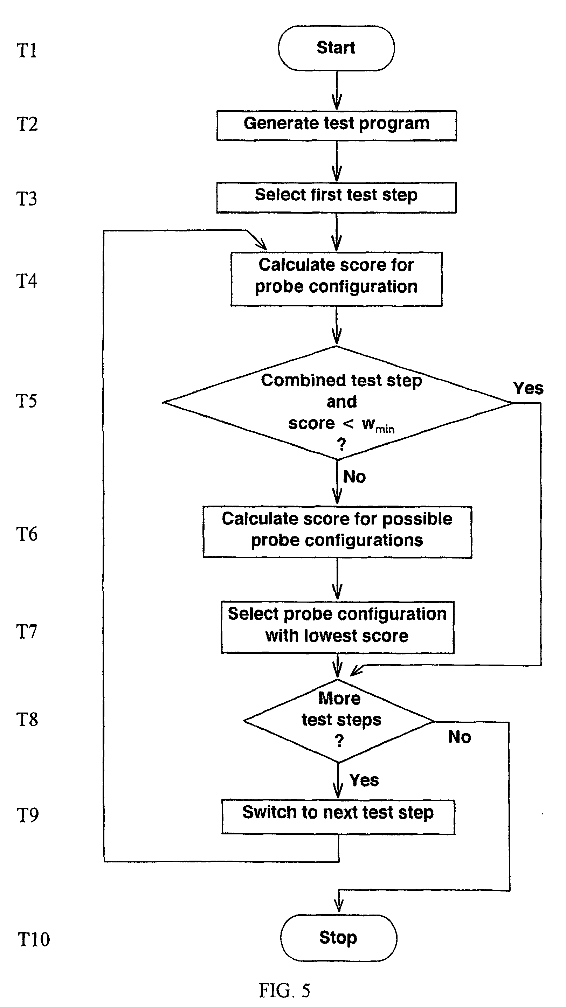

Fig. 5 shows a flow chart of the overall function when determining the most expedient selection of probes and the position of these rules according to the invention.

The purpose of the stated method is to optimize the test program by utilizing the allocation of points described in connection with fig. 4, thereby achieving the advantages mentioned in the preamble.

The method starts in step T1, from which it continues to step T2. In step T2, a test program for the testing apparatus is generated in a manner known per se. This test program is generated as a sequence of so-called test steps, where each test step indicates the test measurement to be performed. Each test step may either comprise a single test measurement or may be a combined test step consisting of several test measurements performed with the same probe configuration. When using combined test steps in a test, the test may be performed faster as the probes do not have to be moved between the combined test measurements. For example, the probes 1, 2 and 3 may be used in a combined test step in which a sequence of test measurements is performed between probes 1 and 2, probes 1 and 3, and probes 2 and 3, respectively. Three test measurements may be made in this manner without moving the probes.

The test program is generated on the basis of data from the print layout of the printed circuit board to be tested. In the generation of the test program, a priority number may be attached to the individual test points in a known manner. This priority number indicates how suitable a point is as a test point. The priority may be attached on the basis of an evaluation of the accessibility of the test point, so that the most easily accessible test points are primarily used.

When the individual test steps are set up in the generation of the test program, allowance may be made for the priority so that high priority test points are mainly used.

When the test program is generated on the basis of data from the print layout, it is necessary to transform the co-ordinates from the print layout to the co-ordinates which are used in the testing apparatus. With knowledge of three connected sets of co-ordinates the unknown quantities are determined in a known manner from the following linear transformation:

$$\begin{pmatrix} X \\ Y \end{pmatrix} = \begin{pmatrix} h \\ k \end{pmatrix} + \begin{pmatrix} i & j \\ l & m \end{pmatrix} \cdot \begin{pmatrix} A \\ B \end{pmatrix}$$

wherein (A,B) is a point from the print layout and (X,Y) is the associated point in the system of co-ordinates of the testing apparatus.

It is frequently desirable to add an offset to the test points with respect to the corresponding points in the print layout. The co-ordinates from the print layout indicate the position of e.g. component legs. If the probes are not to hit the legs of the components, but the soldering immediately at the side of the component leg, an offset value has to be added to the co-ordinates. The offset value is to be added to the point in a desired direction. If data from the print layout contains information on the housing types used, it is possible to attach to the individual test point an offset value depending on the component housing. The direction depends on the position of the point with respect to the component to which it is attached, as described below. The offset value is added in the following manner:

1. Determine, on the basis of the print layout, to which type of component housing the point concerned is attached.
2. Find the offset attached to this type of component housing.
3. Determine the side of the component where the point is positioned with respect to the component.
4. Add offset in a direction depending on the position of the point with respect to the component.

The determination of the position of the point with respect to the component at which the test point is positioned, is made as described in connection with figure 4.

It should be noted that an existing test program to be optimized may alternatively be input in step T2, rather than generating a test program as described above.

The test program will be examined step by step below for optimization purposes, it being taken into consideration that the various probes are more or less suitable for a test measurement at a given test point. This optimization may be made manually, but since this is very onerous for large printed circuit boards, it will frequently be expedient to perform an automatic optimization as described below. The automatic optimization may optionally be followed by a manual verification of the optimized test program and optionally a manual optimization of individual inexpedient test steps.

The method proceeds from step T2 to step T3, in which the first test step of the test program is selected, and continues in step T4. In step T4, a score for the probe configuration used, i.e. probe selection and probe position, is calculated. The allocation of points is described in connection with fig. 4. The method proceeds from step T4 to step T5.

It is checked in step T5 whether the test step concerned is a combined test step. If this is the case, and the score calculated in step T4 does not exceed a given limit value $w_{min}$, no optimization of the test step is performed, and the method jumps to step T8. The reason is that it is accepted in a combined test step that probes with a less well-defined direction of movement are used, since, otherwise, it is not possible to use a large number of probes. Therefore, the score requirements are not nearly as strict for a combined test step as for test measurements which are not combined. When the allocation of points is performed, as described in connection with fig. 8, the limit value $w_{min} = 60$ is a good selection.

If, on the other hand, a combined test step is not involved, or the score exceeds the limit value $w_{min}$, the method continues to step T6, in which the test step concerned is optimized.

In step T6, all combinations of probe configurations useful for the performance of the test measurements in the test step concerned are set up. The associated score is calculated for each individual one of these probe configurations, as described in connection with fig. 4.

The method continues from step T6 to step T7, which comprises selecting the one of the probe configurations set up which has the lowest score. The test program is updated so that this probe configuration is used by the test program.

The method continues from step T7 to step T8, in which it is checked whether there are more test steps. If this is the case, the method continues to step T9, which comprises switching to the next test step. The method jumps from step T9 to T4, in which a score for the probe configuration in this test step is calculated. If it is determined in step T8 that there are no further test steps in the test program, the method jumps to step T10 in which the optimization is terminated.

The optimized test program, which has been optimized using the desired optimization rules, may be used for testing the printed circuit boards concerned, thereby achieving the advantages mentioned in the preamble.

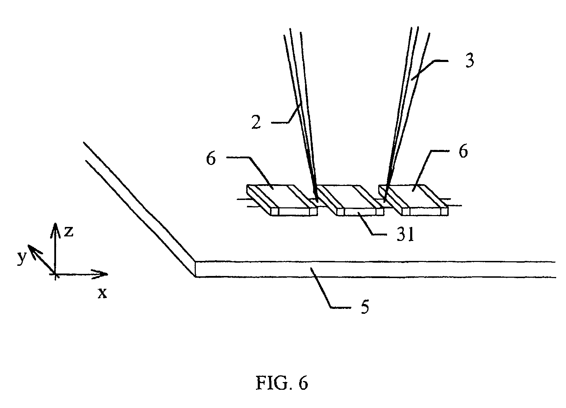

Fig. 6 illustrates the selected probes and the position of these when a method according to the invention is used. The measuring situation corresponds to the situation shown in fig. 1, except that the optimized probe configuration is used. It will be seen that the probes attack from sides ensuring that the component housing does not interfere with the access of the probes to the test points on the printed circuit board, and that the risk of the probes hitting the component is hereby minimized.

The probe configuration is selected on the basis of the method shown in the flow charts in figs. 4 and 5, which has resulted in the score allocations stated in the table below. In the table, "V" and "H" indicate that the row number and the column number indicate the probe used on the test point to the left and to the right of the component 31, respectively. If a probe accesses the test point from an unfortunate side, the probe number is provided with the star symbol "*". The evaluation of whether the access is unfortunate is based on the evaluation made in connection with fig. 3.

| V \ H | *1 | *2 | 3 | 4 |
|---|---|---|---|---|
| 1 | – | 90+30=120 | 30 | 30+30=60 |
| 2 | 30+200=230 | ~ | 0 | 30 |
| *3 | 30+200+90=320 | 90+90=180 | ~ | 30+90=120 |
| *4 | 30+200+30+200 =460 | 90+30+200=320 | 30+200=230 | ~ |

As will appear from the table, the situation in which the probe 2 attacks the test point to the left and the probe 3 attacks the test point to the right, gives the lowest score, and this probe configuration is therefore selected. This situation is shown in fig. 6.

It should be mentioned that the invention may also be implemented using a computer which is used for controlling a testing apparatus having a plurality of inclined probes. The actual test performed using the testing apparatus may thus be controlled by a computer which is connected to the testing apparatus. This computer may also be used in the preceding generation of the test program used for the test. The test program may alternatively be generated by another computer on the basis of the relevant data material, i.e. the print layout and the system of points which reflects the optimization rules, and subsequently be transferred to the testing apparatus or a computer attached to it. No distinction is made below between these uses of a computer, and the term computer is therefore taken to cover both of these situations.

The mode of operation of the testing apparatus may be changed depending on the software used in connection with the computer. For example, a testing apparatus whose mode of operation corresponds to the prior art, may be changed to have a mode of operation corresponding to the invention by changing the existing software or by replacing the existing software by new software. When using a computer having a read means for readable computer medium, e.g. a diskette drive, for a floppy diskette or a CD-ROM drive for a CD-ROM, it may thus be ensured that the mode of operation of the testing apparatus is changed depending on the contents of the readable computer medium.

When a computer is used, the memory means, e.g. the RAM of the computer, is used in connection with the execution of the software. The memory means is used e.g. for containing a data structure which is used for controlling the test probes (1, 2, 3, 4) of the testing apparatus so that the testing apparatus will have a function corresponding to the invention. The mentioned data structure is used for storing the information on the print layout of the printed circuit board, the priority system, the point system and for storage of the test program generated.

A testing apparatus having four probes angled in a given manner with respect to the test plane is used above, and an example using two probes in a test measurement is shown. It should be stressed that this is not to be regarded as a restriction, as the invention encompasses the entire scope defined by the appended claims.

**Claims**

1.  A method of controlling test probes in a testing apparatus for electronic printed circuit boards, at least some of the test probes are inclined and longitudinally moveable according to respective different access angles to the circuit board wherein a test program is generated in dependence on information on print layout and a priority system according to which points are allocated to the individual test points in dependence on their accessibility from the probes,
    **characterized in that** a score for each of at least two probes (1, 2, 3, 4) is attached to each test point (8, 9), so that the score illustrates how expedient it is to use the individual probe at the test point, and that the control of the probes is optimized with respect to probe selection so that a probe having the most expedient spatial direction of movement is selected for a given test point (8, 9).

2.  A method of controlling test probes in a testing apparatus according to claim 1, **characterized in that** the control is optimized by selecting, from a plurality of combinations of probes in the individual test step in the test program, the combination where the attached score reflects the most expedient probe selection for the test points involved in the individual test step.

3.  A method of controlling test probes in a testing apparatus according to claim 2, **characterized in that** the score attached to the individual test point (8, 9) for the individual probe (1, 2, 3, 4) illustrates that the most expedient spatial direction of movement corresponds to the direction of movement which differs least from the perpendicular with respect to the electronic printed circuit board (5).

4.  A method of controlling test probes in a testing apparatus according to claim 2 or 3, **characterized in that** the score attached to the individual test point (8, 9) for the individual probe (1, 2, 3, 4) is selected in dependence on the position of the test point at the associated component (6, 31) with respect to the direction of movement of the test probe.

5.  A method of controlling test probes in a testing apparatus according to claim 4, **characterized in that** the score attached to the individual test point (8, 9) for the individual probe (1, 2, 3, 4) is selected in dependence on the housing type of the component (6, 31) associated with the test point.

6.  A method of controlling test probes in a testing apparatus according to claims 2-5, **characterized in that** the score attached to the individual test point (8, 9) for the individual probe (1, 2, 3, 4) is selected so that the most expedient spatial direction of movement occurs when the angle between the projection of the probe used on the printed circuit board (5) and the longitudinal direction of the track at the test point is as small as possible.

7.  A method of controlling test probes in a testing apparatus according to claims 2-6, **characterized in that** the score attached to the individual test point (8, 9) is selected in dependence on the distance between the test point and an adjacent component as well as the type of the adjacent component.

8.  A method of controlling test probes in a testing apparatus according to claims 2-7, **characterized in that** the optimum probe selection for a test step involving a plurality of test points is found by arithmetic operations on the scores attached to these test points.

9.  A method of controlling test probes in a testing apparatus according to claim 8, **characterized in that**, when a score is attached to a given test point (8, 9) a low score is used for reflecting a probe with an expedient direction, and a high score is used for reflecting a probe with an inexpedient direction, and that the most expedient probe selection is the probe selection where the sum of the scores attached to the test points is smallest.

10. A testing apparatus for electronic printed circuit boards, comprising means for controlling test probes and means for generating a test program in dependence on information on print layout, as well as means for allocating points, on the basis of a priority system, to the individual test points in dependence on their accessibility from the probes, **characterized in that** it comprises probes (1, 2, 3, 4), of which at least some are inclined and longitudinally movable according to respective different access angles to the circuit board, and means adapted to optimize the control with respect to probe selection using a system of points so that the means selects a probe with the most expedient spatial direction of movement with respect to each test point (8, 9) involved in a test step.

11. A readable computer medium whose contents cause a computer to

control test probes (1, 2, 3, 4) in a testing apparatus for electronic printed circuit boards, of which at least some are inclined and longitudinally movable according to respective different access angels to the circuit board by generating a test program in dependence on information on print layout and a system of points according to which points are allocated to the individual test points (8, 9) in dependence on their accessibility from the probes, and by optimizing the control with respect to probe selection so that a probe with the most expedient spatial direction of movement with respect to a given test point is selected.

12. A computer memory means containing a data structure which is used for

controlling test probes (1, 2, 3, 4) in a testing apparatus for electronic printed circuit boards, of which at least some are inclined and longitudinally movable according to respective different access angles to the circuit board, generating a test program in dependence on information on print layout and a system of points according to which points are allocated to the individual test points (8, 9) in dependence on their accessibility from the probes, and optimizing the control with respect to probe selection so that a probe with the most expedient spatial direction of movement with respect to a given test point (8, 9) is selected, said data structure comprising entries for storing information on the print layout, the priority system, the system of points and the generated test program.

**Patentansprüche**

1. Verfahren zum Steuern von Prüfspitzen in einer Prüfvorrichtung für elektronische Leiterplatten, wobei mindestens einige der Prüfspitzen entsprechend respektiven unterschiedlichen Zugriffswinkeln zur Leiterplatte geneigt und in Längsrichtung bewegbar sind, bei dem ein Prüfprogramm in Abhängigkeit von Information über Drucklayout und einem Prioritätssystem generiert wird, entsprechend welchem den einzelnen Prüfpunkten in Abhängigkeit von ihrer Zugänglichkeit von den Prüfspitzen Punkte zugewiesen werden, **dadurch gekennzeichnet, dass** jedem Prüfpunkt (8, 9) eine Punktbewertung für jede von mindestens zwei Prüfspitzen (1, 2, 3, 4) beigefügt wird, so dass die Punktbewertung veranschaulicht, wie zweckmäßig es ist, die einzelne Prüfspitze an dem Prüfpunkt zu verwenden, und dass die Steuerung der Prüfspitzen in Bezug zur Prüfspitzenauswahl so optimiert wird, dass eine Prüfspitze mit der zweckmäßigsten räumlichen Bewegungsrichtung für einen gegebenen Prüfpunkt (8, 9) ausgewählt wird.

2. Verfahren zum Steuern von Prüfspitzen in einer Prüfvorrichtung nach Anspruch 1, **dadurch gekennzeichnet, dass** die Steuerung durch Auswählen aus einer Mehrzahl von Kombinationen von Prüfspitzen in dem einzelnen Prüfschritt im Prüfprogramm optimiert wird, und zwar der Kombination, bei der die beigefügte Punktbewertung die zweckmäßigste Prüfspitzenauswahl für die in dem einzelnen Prüfschritt einbezogenen Prüfpunkte widerspiegelt.

3. Verfahren zum Steuern von Prüfspitzen in einer Prüfvorrichtung nach Anspruch 2, **dadurch gekennzeichnet, dass** die dem einzelnen Prüfpunkt (8, 9) beigefügte Punktbewertung für die einzelne Prüfspitze (1, 2, 3, 4) veranschaulicht, dass die zweckmäßigste räumliche Bewegungsrichtung der Bewegungsrichtung entspricht, die sich am wenigsten von der Senkrechten in Bezug zur elektronischen Leiterplatte (5) unterscheidet.

4. Verfahren zum Steuern von Prüfspitzen in einer Prüfvorrichtung nach Anspruch 2 oder 3, **dadurch gekennzeichnet, dass** die dem einzelnen Prüfpunkt (8, 9) beigefügte Punktbewertung für die einzelne Prüfspitze (1, 2, 3, 4) in Abhängigkeit von der Position des Prüfpunkts am zugeordneten Bauelement (6, 31) in Bezug zur Bewegungsrichtung der Prüfspitze ausgewählt wird.

5. Verfahren zum Steuern von Prüfspitzen in einer Prüfvorrichtung nach Anspruch 4, **dadurch gekennzeichnet, dass** die dem einzelnen Prüfpunkt (8, 9) beigefügte Punktbewertung für die einzelne Prüfspitze (1, 2, 3, 4) in Abhängigkeit vom Gehäusetyp des dem Prüfpunkt zugeordneten Bauelements (6, 31) ausgewählt wird.

6. Verfahren zum Steuern von Prüfspitzen in einer Prüfvorrichtung nach den Ansprüchen 2-5, **dadurch gekennzeichnet, dass** die dem einzelnen Prüfpunkt (8, 9) beigefügte Punktbewertung für die einzelne Prüfspitze (1, 2, 3, 4) so ausgewählt wird, dass die zweckmäßigste räumliche Bewegungsrichtung auftritt, wenn der Winkel zwischen der Projektion der verwendeten Prüfspitze auf die Leiterplatte (5) und der Längsrichtung der Leiterbahn am Prüfpunkt so klein wie möglich ist.

7. Verfahren zum Steuern von Prüfspitzen in einer Prüfvorrichtung nach den Ansprüchen 2-6, **dadurch gekennzeichnet, dass** die dem einzelnen Prüfpunkt (8, 9) beigefügte Punktbewertung in Abhängigkeit vom Abstand zwischen dem Prüfpunkt und einem benachbarten Bauelement sowie dem Typ des benachbarten Bauelements ausgewählt wird.

**8.** Verfahren zum Steuern von Prüfspitzen in einer Prüfvorrichtung nach den Ansprüchen 2-7, **dadurch gekennzeichnet, dass** die optimale Prüfspitzenauswahl für einen Prüfschritt, der eine Mehrzahl von Prüfpunkten einbezieht, durch Rechenoperationen auf den diesen Prüfpunkten beigefügten Punktbewertungen gefunden wird.

**9.** Verfahren zum Steuern von Prüfspitzen in einer Prüfvorrichtung nach Anspruch 8, **dadurch gekennzeichnet, dass**, wenn einem gegebenen Prüfpunkt (8, 9) eine Punktbewertung beigefügt wird, eine geringe Punktbewertung verwendet wird, um eine Prüfspitze mit einer zweckmäßigen Richtung widerzuspiegeln, und eine hohe Punktbewertung verwendet wird, um eine Prüfspitze mit einer unzweckmäßigen Richtung widerzuspiegeln, und dass die zweckmäßigste Prüfspitzenauswahl die Prüfspitzenauswahl ist, bei der die Summe der den Prüfpunkten beigefügten Punktbewertungen am kleinsten ist.

**10.** Prüfvorrichtung für elektronische Leiterplatten, umfassend eine Einrichtung zum Steuern von Prüfspitzen und eine Einrichtung zum Generieren eines Prüfprogramms in Abhängigkeit von Information über Drucklayout sowie eine Einrichtung zum Zuweisen von Punkten auf Grundlage eines Prioritätssystems zu den einzelnen Prüfpunkten in Abhängigkeit von ihrer Zugänglichkeit von den Prüfspitzen, **dadurch gekennzeichnet, dass** sie umfasst: Prüfspitzen (1, 2, 3, 4), von denen mindestens einige entsprechend respektiven unterschiedlichen Zugriffswinkeln zur Leiterplatte geneigt und in Längsrichtung bewegbar sind, und eine Einrichtung, die angepasst ist, um die Steuerung in Bezug zur Prüfspitzenauswahl zu optimieren,
wobei ein System von Punkten verwendet wird, so dass die Einrichtung eine Prüfspitze mit der zweckmäßigsten räumlichen Bewegungsrichtung in Bezug zu jedem in einem Prüfschritt einbezogenen Prüfpunkt (8, 9) auswählt.

**11.** Lesbares Computermedium, dessen Inhalt bewirkt, dass ein Computer
Prüfspitzen (1, 2, 3, 4) in einer Prüfvorrichtung für elektronische Leiterplatten steuert, von denen mindestens einige entsprechend respektiven unterschiedlichen Zugriffswinkeln zur Leiterplatte geneigt und in Längsrichtung bewegbar sind, durch
Generieren eines Prüfprogramms in Abhängigkeit von Information über Printlayout und einem System von Punkten, entsprechend welchem den einzelnen Prüfpunkten (8, 9) in Abhängigkeit von ihrer Zugänglichkeit von den Prüfspitzen Punkte zugewiesen werden,
und durch Optimieren der Steuerung in Bezug zur Prüfspitzenauswahl, so dass eine Prüfspitze mit der zweckmäßigsten räumlichen Bewegungsrichtung in Bezug zu einem gegebenen Prüfpunkt ausgewählt wird.

**12.** Computerspeichereinrichtung, enthaltend eine Datenstruktur, die verwendet wird zum
Steuern von Prüfspitzen (1, 2, 3, 4) in einer Prüfvorrichtung für elektronische Leiterplatten, von denen mindestens einige entsprechend respektiven unterschiedlichen Zugriffswinkeln zur Leiterplatte geneigt und in Längsrichtung bewegbar sind, Generieren eines Prüfprogramms in Abhängigkeit von Information über Drucklayout und einem System von Punkten, entsprechend welchem den einzelnen Prütpunkten (8, 9) in Abhängigkeit von ihrer Zugänglichkeit von den Prüfspitzen Punkte zugewiesen werden,
und Optimieren der Steuerung in Bezug zur Prüfspitzenauswahl, so dass eine Prüfspitze mit der zweckmäßigsten räumlichen Bewegungsrichtung in Bezug zu einen gegebenen Prüfpunkt (8, 9) ausgewählt wird,
wobei die Datenstruktur Eintrittsstellen zum Speichern von Information über das Drucklayout, des Prioritätssystems, des Systems von Punkten und des generierten Prüfprogramms umfasst.

**Revendications**

**1.** , Procédé de contrôle de sondes d'essai dans un appareil d'essai pour cartes électroniques de circuits imprimés, au moins certaines sondes d'essai sont inclinées et mobiles longitudinalement selon différents angles d'accès respectifs par rapport au circuit imprimé dans lequel un programme d'essai est généré en fonction de l'information concernant le schéma du circuit et un système de priorité selon lequel des points sont attribués aux points de mesure individuels en fonction de leur accessibilité à partir des sondes, **caractérisé en ce qu'**une cote pour chacune des au moins deux sondes (1, 2, 3, 4) est attribuée à chaque point de mesure (8, 9), de façon à ce que la cote indique le caractère approprié de l'utilisation de la sonde individuelle au point de mesure, et que le contrôle des sondes soit optimisé par rapport au choix d'une sonde de façon à ce qu'une sonde dont la direction du mouvement dans l'espace est la plus appropriée soit choisie pour un point de mesure donné (8, 9).

**2.** Procédé de contrôle de sondes d'essai dans un appareil d'essai selon la revendication 1, **caractérisé en ce que** le contrôle est optimisé en choisissant, parmi un ensemble de combinaisons de sondes dans l'étape d'essai individuelle dans le programme d'essai, la combinaison pour laquelle la cote attribuée indique le choix d'une sonde le plus approprié pour les points de mesure concernés dans l'étape d'essai individuelle.

**3.** Procédé de contrôle de sondes d'essai dans un appareil d'essai selon la revendication 2, **caractérisé en ce que** la cote attribuée au point de mesure individuel (8, 9) pour la sonde individuelle (1, 2, 3, 4) indique que la direction du mouvement dans l'espace la plus appropriée correspond à la direction du mouvement qui diffère le moins de la perpendiculaire par rapport à la carte électronique du circuit imprimé (5).

**4.** Procédé de contrôle de sondes d'essai dans un appareil d'essai selon la revendication 2 ou la revendication 3, **caractérisé en ce que** la cote attribuée au point de mesure individuel (8, 9) pour la sonde individuelle (1, 2, 3, 4) est choisie en fonction de la position du point de mesure au composé associé (6, 31) par rapport à la direction du mouvement de la sonde d'essai.

**5.** Procédé de contrôle de sondes d'essai dans un appareil d'essai selon la revendication 4, **caractérisé en ce que** la cote attribuée au point de mesure individuel (8, 9) pour la sonde individuelle (1, 2, 3, 4) est choisie en fonction du type de boîtier du composé (6, 31) associé au point de mesure.

**6.** Procédé de contrôle de sondes d'essai dans un appareil d'essai selon les revendications 2 à 5, **caractérisé en ce que** la cote attribuée au point de mesure individuel (8, 9) pour la sonde individuelle (1, 2, 3, 4) est choisie de façon à ce que la direction du mouvement dans l'espace la plus appropriée soit obtenue lorsque l'angle entre la projection de la sonde utilisée sur le circuit imprimé (5) et la direction longitudinale de la piste au point de mesure est le plus petit possible.

**7.** Procédé de contrôle de sondes d'essai dans un appareil d'essai selon les revendications 2 à 6, **caractérisé en ce que** la cote attribuée au point de mesure individuel (8, 9) est choisie en fonction de la distance entre le point de mesure et un composé adjacent, ainsi qu'en fonction du type du composé adjacent.

**8.** Procédé de contrôle de sondes d'essai dans un appareil d'essai selon les revendications 2 à 7, **caractérisé en ce que** le meilleur choix d'une sonde pour une étape d'essai comprenant un ensemble de points de mesure est déterminé au moyen d'opérations arithmétiques effectuées sur les cotes attribuées auxdits points de mesure.

**9.** Procédé de contrôle de sondes d'essai dans un appareil d'essai selon la revendication 8, **caractérisé en ce que**, lorsqu'une cote est attribuée à un point de mesure donné (8, 9), une cote basse est utilisée pour caractériser une sonde dont la direction est appropriée, et une cote élevée est utilisée pour caractériser une sonde dont la direction est inappropriée, et que le choix d'une sonde le plus approprié est le choix d'une sonde pour lequel la somme des cotes attribuées aux points de mesure est la plus petite.

**10.** Appareil d'essai pour cartes électroniques de circuits imprimés, comprenant des moyens pour contrôler des sondes d'essai et des moyens pour générer un programme d'essai en fonction de l'information concernant le schéma du circuit, ainsi que des moyens pour attribuer des points, sur la base d'un système de priorités, à des points de mesure individuels en fonction de leur accessibilité à partir des sondes, **caractérisé en ce qu'**il comprend des sondes (1, 2, 3, 4), parmi lesquelles au moins certaines sont inclinées et mobiles longitudinalement selon différents angles d'accès respectifs par rapport au circuit imprimé, et des moyens adaptés pour optimiser le contrôle par rapport au choix d'une sonde en utilisant un système de points de façon à ce que les moyens choisissent une sonde dont la direction du mouvement dans l'espace est la plus appropriée par rapport à chaque point de mesure (8, 9) concerné dans une étape d'essai.

**11.** Support informatique exploitable dont le contenu entraîne le contrôle par un ordinateur de sondes d'essai (1, 2, 3, 4), dans un appareil d'essai pour des cartes électroniques de circuits imprimés, dont au moins certaines sont inclinées et mobiles longitudinalement selon différents angles d'accès respectifs par rapport au circuit imprimé

en générant un programme d'essai en fonction de l'information concernant le schéma du circuit et un système de points selon lequel des points sont attribués à des points de mesure individuels (8, 9) en fonction de leur accessibilité à partir des sondes,

et en optimisant le contrôle par rapport au choix d'une sonde de façon à ce qu'une sonde dont la direction du mouvement dans l'espace est la plus appropriée par rapport à un point de mesure donné soit choisie.

12. Des moyens de mémoire informatique comprenant une structure de données utilisés pour

contrôler les sondes d'essai (1, 2, 3, 4) dans un appareil d'essai pour des cartes électroniques de circuits imprimés, dont au moins certaines sont inclinées et mobiles longitudinalement selon différents angles d'accès respectifs par rapport au circuit imprimé, en générant un programme d'essai en fonction de l'information concernant le schéma du circuit et un système de points selon lequel des points sont attribués aux points de mesure individuels (8, 9) en fonction de leur accessibilité à partir des sondes,

et optimiser le contrôle par rapport au choix d'une sonde de façon à ce qu'une sonde dont la direction du mouvement dans l'espace est la plus appropriée par rapport à un point de mesure donné (8, 9) soit choisie,

ladite structure de données comprenant des entrées pour enregistrer des informations concernant le schéma du circuit, le système de priorités, le système de points et le programme d'essai généré.

FIG. 1

FIG. 2

FIG. 3

P1 Start

P2 s = 0

P3 n = 1

P4 Is probe No. n used ? — No

Yes

P5 Priority $< P_{max}$ ? — No

Yes

P6 s = s + p(n)

P7 Access from undesired side ? — No

Yes

P8 s = s + u(n)

P9 n = n + 1

P10 $n > n_{max}$ ? — No

Yes

P11 Stop

FIG. 4

T1

Start

T2

Generate test program

T3

Select first test step

T4

Calculate score for
probe configuration

T5

Combined test step
and
score < $w_{min}$
?

Yes

No

T6

Calculate score for possible
probe configurations

T7

Select probe configuration
with lowest score

T8

More
test steps
?

No

Yes

T9

Switch to next test step

T10

Stop

FIG. 5

FIG. 6